# FASCICULE DE BREVET EUROPEEN

(11) **EP 3 053 200 B1**
(45) Date de publication et mention de la délivrance du brevet: **01.09.2021**
(21) Numéro de dépôt: 14789320.0
(22) Date de dépôt: 30.09.2014
(51) Int. Cl.: H01L 33/08, H01L 33/18, H01L 27/06, H01L 33/14, H05B 33/00, H01L 29/772, H01L 29/06, H01L 27/15, H01L 33/24

(54) **DISPOSITIF OPTOÉLECTRONIQUE A DIODES ÉLECTROLUMINESCENTES**
OPTOELEKTRONISCHES BAUTEIL MIT LEUCHTDIODEN
OPTOELECTRONIC DEVICE WITH LIGHT-EMTTING DIODES

(30) Priorité: 30.09.2013 FR 1359411
(43) Date de publication de la demande: 10.08.2016
(73) Titulaire: Aledia, 38130 Echirolles (FR)
(72) Inventeur: BOUVIER, Christophe, F-38000 Grenoble (FR); DORNEL, Erwan, F-38600 Fontaine (FR); HUGON, Xavier, F-38470 Teche (FR); CAGLI, Carlo, F-38000 Grenoble (FR)
(74) Mandataire: Cabinet Beaumont
(86) Numéro de dépôt international: PCT/FR2014/052471
(87) Numéro de publication internationale: WO 2015/044619

(56) Documents cités:
- DE-A1-102004 005 269
- DE-A1-102009 006 177
- US-A- 5 362 972
- US-A1- 2003 020 132
- US-A1- 2006 056 123
- US-A1- 2008 036 038
- US-A1- 2008 116 465
- US-A1- 2008 149 944
- US-A1- 2009 321 738
- US-A1- 2011 079 796
- US-A1- 2011 260 210
- US-A1- 2012 061 646
- KISHINO K ET AL: "GaN nanocolumn light-emitters, growth, and optical characterization", 2013 CONFERENCE ON LASERS AND ELECTRO-OPTICS PACIFIC RIM (CLEOPR), IEEE, 30 juin 2013 (2013-06-30), pages 1-2, XP032481392, DOI: 10.1109/CLEOPR.2013.6599923 [extrait le 2013-09-13]
- WILDESON ISAAC ET AL: "III-nitride nanopyramid light emitting diodes grown by organometallic vapor phase epitaxy", JOURNAL OF APPLIED PHYSICS, AMERICAN INSTITUTE OF PHYSICS, 2 HUNTINGTON QUADRANGLE, MELVILLE, NY 11747, vol. 108, no. 4, 18 août 2010 (2010-08-18) , pages 44303-44303, XP012142689, ISSN: 0021-8979, DOI: 10.1063/1.3466998
- KISHINO K ET AL: "Selective-area growth of GaN nanocolumns on titanium-mask-patterned silicon (111) substrates by RF-plasma-assisted molecular-beam epitaxy", ELECTRONIC LETTERS, THE INSTITUTION OF ENGINEERING AND TECHNOLOGY, vol. 44, no. 13, 19 juin 2008 (2008-06-19) , pages 819-821, XP006031356, ISSN: 1350-911X, DOI: 10.1049/EL:20081323

## Description

La présente demande de brevet revendique la priorité de la demande de brevet français FR13/59411.

### Domaine

La présente invention concerne de façon générale les dispositifs optoélectroniques à base de matériaux semiconducteurs et leurs procédés de fabrication. La présente invention concerne plus particulièrement les dispositifs optoélectroniques comprenant des diodes électroluminescentes formées par des éléments tridimensionnels, notamment des microfils ou nanofils semiconducteurs.

### Exposé de l'art antérieur

Par dispositifs optoélectroniques à diodes électroluminescentes, on entend des dispositifs adaptés à effectuer la conversion d'un signal électrique en un rayonnement électromagnétique, et notamment des dispositifs dédiés à l'émission d'un rayonnement électromagnétique, notamment de la lumière. Des exemples d'éléments tridimensionnels adaptés à la réalisation de diodes électroluminescentes sont des microfils ou nanofils comprenant un matériau semiconducteur à base d'un composé comportant majoritairement au moins un élément du groupe III et un élément du groupe V (par exemple du nitrure de gallium GaN), appelé par la suite composé III-V, ou comportant majoritairement au moins un élément du groupe II et un élément du groupe VI (par exemple de l'oxyde de zinc ZnO), appelé par la suite composé II-VI.

Les éléments tridimensionnels, notamment des microfils ou nanofils semiconducteurs, de plusieurs dispositifs optoélectroniques peuvent être formés sur un substrat qui est ensuite découpé pour délimiter des dispositifs optoélectroniques individuels. Chaque dispositif optoélectronique est alors disposé dans un boîtier, notamment pour protéger les éléments tridimensionnels, et le boîtier est fixé à un support, par exemple un circuit imprimé.

Il peut être souhaitable d'associer un circuit électronique au dispositif optoélectronique. Il s'agit, par exemple, d'un circuit de commande de l'alimentation des diodes électroluminescentes, d'un circuit de protection des diodes électroluminescentes contre les décharges électrostatiques ou d'un circuit de détection de la température des diodes électroluminescentes. Ces circuits électroniques sont réalisés séparément du dispositif optoélectronique, puis fixés au support et connectés au boîtier. L'encombrement dû aux circuits électroniques associés au dispositif optoélectronique peut être important. Le procédé de fabrication d'un système électronique comprenant le dispositif optoélectronique comprend donc, en plus des étapes de fabrication du dispositif optoélectronique, des étapes distinctes de fabrication des circuits électroniques et des étapes de connexion des circuits électroniques aux dispositifs optoélectroniques. Ces étapes augmentent le coût de fabrication du système optoélectronique.

Les documents US 2012/061646, US 2009/321738, DE 10 2009 006177, US 2011/079796, et la publication de Kishino et al intitulée "GaN Nanocolumn Light-Emitters, Growth, and Optical Characterization" 2013 Conférence on Lasers and Electro-Optics Pacific Rim (CLEO-PR), 30 juin 2013, décrivent des dispositifs optoélectroniques à diodes électroluminescentes.

### Résumé

Ainsi, un objet d'un mode de réalisation est de pallier au moins en partie les inconvénients des dispositifs optoélectroniques à diodes électroluminescentes, notamment à microfils ou nanofils, décrits précédemment et de leurs procédés de fabrication.

Un autre objet d'un mode de réalisation est de réduire l'encombrement d'un système électronique comprenant un dispositif optoélectronique.

Un autre objet d'un mode de réalisation est de réduire le nombre d'étapes du procédé de fabrication d'un système électronique comprenant un dispositif optoélectronique.

Un autre objet d'un mode de réalisation est que les dispositifs optoélectroniques à diodes électroluminescentes puissent être fabriqués à une échelle industrielle et à bas coût.

Ainsi, un mode de réalisation prévoit un dispositif optoélectronique comprenant :
un substrat semiconducteur non dopé ou dopé d'un premier type de conductivité ;
une première région semiconductrice reliée électriquement au substrat, dopée du premier type de conductivité ou d'un deuxième type de conductivité opposé au premier type, et plus fortement dopée que le substrat ;
un premier ensemble de premières diodes électroluminescentes reposant sur la première région semiconductrice, les premières diodes électroluminescentes comprenant des éléments semiconducteurs filaires, coniques ou tronconiques ; et
une portion conductrice au contact de la première région semiconductrice.

Selon un mode de réalisation, la première région semiconductrice est obtenue par une ou plusieurs étapes d'implantation ionique.

Selon un mode de réalisation, la première région semiconductrice est obtenue par une étape d'homo-épitaxie.

Selon un mode de réalisation, le dispositif comprend, en outre, une première couche d'électrode, au moins partiellement transparente, recouvrant chaque première diode électroluminescente et une première couche conductrice recouvrant la première couche d'électrode autour des premières diodes électroluminescentes.

Selon un mode de réalisation, le dispositif comprend, en outre, au moins une portion isolante s'étendant le long d'au moins un bord latéral de la première région semiconductrice.

Selon un mode de réalisation, le dispositif comprend, en outre, au moins une deuxième région semiconductrice dopée d'un type de conductivité opposé à la première région semiconductrice et s'étendant le long d'au moins un bord latéral de la première région semiconductrice.

Selon un mode de réalisation, le substrat est monolithique.

Selon un mode de réalisation, le substrat est divisé en une couche semiconductrice, contenant la première région semiconductrice, et séparée du reste du substrat par une couche isolante.

Selon un mode de réalisation, la couche semiconductrice est choisie parmi le groupe comprenant le silicium, le germanium, le carbure de silicium et les composés III-V.

Selon un mode de réalisation, le substrat est choisi parmi le groupe comprenant le silicium, le germanium, le carbure de silicium et les composés III-V.

Selon un mode de réalisation, le substrat est un matériau isolant, par exemple de l'oxyde de silicium ou de l'oxyde l'aluminium.

Selon un mode de réalisation, la concentration de dopants du substrat est inférieure ou égale à 10¹⁵ atomes/cm³ et la concentration de dopants de la première région semiconductrice est comprise entre 5*10¹⁶ et 2*10²⁰ atomes/cm³.

Selon un mode de réalisation, le dispositif comprend, en outre, au moins un composant électronique formé au moins en partie dans le substrat.

Selon un mode de réalisation, le composant électronique est compris dans le groupe comprenant une diode, une diode Zener, une diode à avalanche, un transistor bipolaire, un transistor à effet de champ à grille métal-oxyde-semiconducteur, une résistance, une capacité métal-oxyde-semiconducteur, une capacité métal-isolant-métal, un thyristor, un varacteur, une mémoire volatile et une mémoire non volatile.

Selon un mode de réalisation, le dispositif comprend :
une troisième région semiconductrice reliée électriquement au substrat, dopée du premier type de conductivité ou d'un deuxième type de conductivité opposé au premier type, et plus fortement dopée que le substrat ;
un deuxième ensemble de diodes électroluminescentes reposant sur la troisième région semiconductrice, les diodes électroluminescentes du deuxième ensemble comprenant des éléments semiconducteurs filaires, coniques ou tronconiques ; et
une deuxième couche d'électrode recouvrant chaque deuxième diode électroluminescente et une deuxième couche conductrice recouvrant la deuxième couche d'électrode autour des premières diodes électroluminescentes, la deuxième couche d'électrode ou la deuxième couche conductrice étant au contact de la première région semiconductrice.

Selon un mode de réalisation, le dispositif comprend une quatrième région semiconductrice reliée électriquement au substrat et distante de la première région semiconductrice, du même type de conductivité que la première région semiconductrice, plus fortement dopée que le substrat, et reliée à une électrode des premières diodes électroluminescentes.

Selon un mode de réalisation, le dispositif comprend une cinquième région semiconductrice englobant la quatrième région semiconductrice.

Selon un mode de réalisation, la cinquième région semiconductrice englobe, en outre, la première région semiconductrice.

Selon un mode de réalisation, le dispositif comprend :
- une sixième région semiconductrice reliée électriquement au substrat, du même type de conductivité que la première région semiconductrice ;
- une septième région semiconductrice reliée électriquement au substrat, du type de conductivité opposé à la première région semiconductrice ;
- une huitième région semiconductrice au contact du substrat et du même type de conductivité que la sixième région semiconductrice, reliée à la première région semiconductrice ou reliée à la sixième région semiconductrice ; et
- une neuvième région semiconductrice du même type de conductivité que la septième région semiconductrice,
et la neuvième région semiconductrice s'étend entre les sixième et huitième régions semiconductrices et est reliée à la septième région semiconductrice ou la neuvième région semiconductrice s'étend entre les première et huitième régions semiconductrices, la neuvième région semiconductrice étant reliée à la septième région semiconductrice.

Selon un mode de réalisation, le dispositif comprend une dizième et une onzième régions semiconductrices, reliées l'une à l'autre, de types de conductivité opposés et toutes deux séparées de la première région semiconductrice par au moins une portion isolante ou semiconductrice s'étendant le long d'au moins un bord latéral de la première région semiconductrice.

### Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :
les figures 1 à 4 sont des vues en coupe, partielles et schématiques, de modes de réalisation d'un dispositif optoélectronique à microfils ou nanofils fabriqués sur un substrat semiconducteur ;
les figures 5 à 9 sont des vues en coupe, partielles et schématiques, de modes de réalisation d'un dispositif optoélectronique comprenant deux ensembles de diodes électroluminescentes connectés en série ;
les figures 10 et 11 représentent des exemples de circuits de protection d'une diode électroluminescente contre les décharges électrostatiques ;
les figures 12, 13 et 14 sont des vues en coupe, partielles et schématiques, de modes de réalisation d'un dispositif optoélectronique comprenant un circuit de protection à base d'une ou de deux diodes Zener ;
la figure 15 représente un exemple de circuit de mesure de la température ;
la figure 16 est une vue en coupe, partielle et schématique, d'un mode de réalisation d'un dispositif optoélectronique à microfils ou nanofils comprenant, en outre, une diode de détection de la température ;
les figures 17, 18 et 19 sont des vues de dessus, partielles et schématiques, de dispositifs optoélectroniques représentant des agencements des diodes électroluminescentes et d'une diode de détection de température ;
les figures 20 et 21 sont des vues en coupe, partielles et schématiques, de modes de réalisation d'un dispositif optoélectronique à microfils ou nanofils comprenant, en outre, un transistor bipolaire ;
la figure 22 est une vue en coupe, partielle et schématique, d'un mode de réalisation d'un dispositif optoélectronique à microfils ou nanofils formé sur une plaque d'un substrat avant la découpe du substrat ; et
la figure 23 est une vue de dessus, partielle et schématique, du dispositif optoélectronique de la figure 22.

### Description détaillée

Par souci de clarté, de mêmes éléments ont été désignés par de mêmes références aux différentes figures et, de plus, comme cela est habituel dans la représentation des circuits électroniques, les diverses figures ne sont pas tracées à l'échelle. En outre, seuls les éléments utiles à la compréhension de la présente description ont été représentés et sont décrits.

Dans la suite de la description, sauf indication contraire, les termes "sensiblement", "environ" et "de l'ordre de" signifient "à 10 % près". En outre, on entend par "composé principalement constitué d'un matériau" ou "composé à base d'un matériau" qu'un composé comporte une proportion supérieure ou égale à 95 % dudit matériau, cette proportion étant préférentiellement supérieure à 99 %.

La présente description concerne des dispositifs optoélectroniques à éléments tridimensionnels, par exemple des microfils, des nanofils, des éléments coniques ou des éléments tronconiques. Dans la suite de la description, des modes de réalisation sont décrits pour des dispositifs optoélectroniques à microfils ou à nanofils. Toutefois, ces modes de réalisation peuvent être mis en oeuvre pour des éléments tridimensionnels autres que des microfils ou des nanofils, par exemple des éléments tridimensionnels en forme de pyramide.

Le terme "microfil" ou "nanofil" désigne une structure tridimensionnelle de forme allongée selon une direction privilégiée dont au moins deux dimensions, appelées dimensions mineures, sont comprises entre 5 nm et 2,5 µm, de préférence entre 50 nm et 2,5 µm, la troisième dimension, appelée dimension majeure, étant au moins égale à 1 fois, de préférence au moins 5 fois et encore plus préférentiellement au moins 10 fois, la plus grande des dimensions mineures. Dans certains modes de réalisation, les dimensions mineures peuvent être inférieures ou égales à environ 1 µm, de préférence comprises entre 100 nm et 1 µm, plus préférentiellement entre 100 nm et 300 nm. Dans certains modes de réalisation, la hauteur de chaque microfil ou nanofil peut être supérieure ou égale à 500 nm, de préférence comprise entre 1 µm et 50 µm.

Dans la suite de la description, on utilise le terme "fil" pour signifier "microfil ou nanofil". De préférence, la ligne moyenne du fil qui passe par les barycentres des sections droites, dans des plans perpendiculaires à la direction privilégiée du fil, est sensiblement rectiligne et est appelée par la suite "axe" du fil.

Selon un mode de réalisation, pour la fabrication d'un dispositif optoélectronique, il est utilisé un substrat semiconducteur non dopé ou faiblement dopé d'un premier type de conductivité et les diodes électroluminescentes sont réalisées sur une région fortement dopée d'un deuxième type de conductivité opposé au premier type et s'étendant dans le substrat depuis la face supérieure du substrat. Le substrat correspond, par exemple, à un substrat de silicium monocristallin non dopé ou faiblement dopé utilisé de façon classique dans les procédés de fabrication de circuits intégrés.

La polarisation de la base des diodes électroluminescentes est réalisée par la région fortement dopée qui est en contact avec toutes les diodes électroluminescentes. La région fortement dopée est relativement isolée électriquement du reste du substrat. D'autres composants électroniques peuvent alors être réalisés dans ou sur ce substrat de façon intégrée avec les diodes électroluminescentes. Les composants électroniques supplémentaires peuvent correspondre à des diodes pn, des diodes Zener, des diodes à avalanche, des transistors à effet de champ à métal-oxyde-semiconducteur, également appelés transistors MOS, des transistors bipolaires, des résistances, des capacités métal-oxyde-semiconducteur, également appelées capacités MOS, des capacités métal-isolant-métal, également appelées capacités MIM, des thyristors, des varacteurs, des mémoires volatiles, par exemple des mémoires dynamiques à accès aléatoire appelées DRAM, des mémoires non-volatiles, par exemple des mémoires flash.

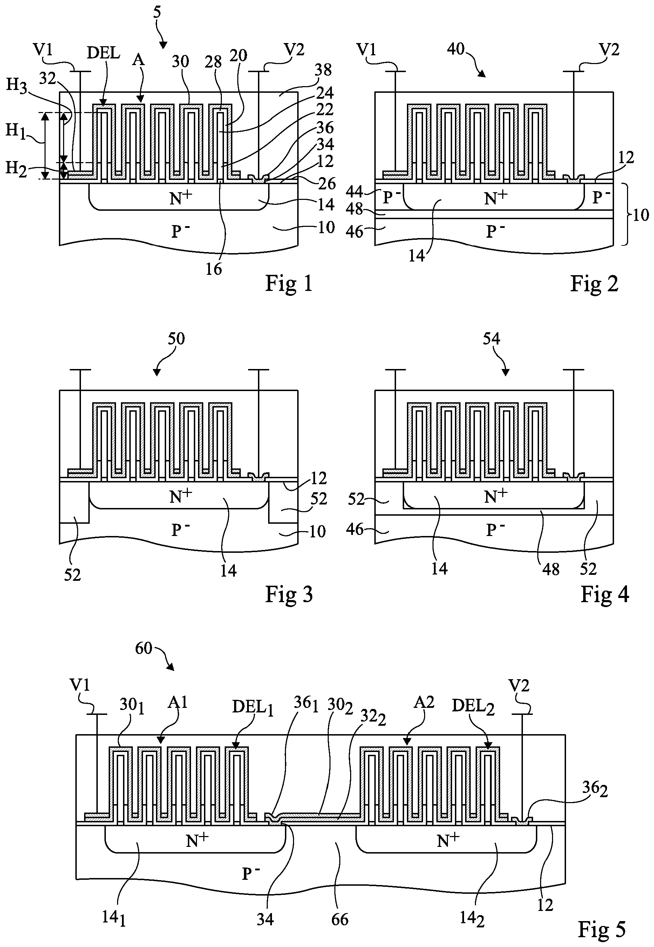

La figure 1 est une vue en coupe, partielle et schématique, d'un mode de réalisation d'un dispositif optoélectronique 5 réalisé à partir de fils tels que décrits précédemment et adaptés à l'émission d'un rayonnement électromagnétique.

En figure 1, on a représenté une structure comprenant, du bas vers le haut :
un substrat semiconducteur 10 non dopé ou faiblement dopé d'un premier type de conductivité, comprenant une face supérieure 12, de préférence plane au moins au niveau des diodes électroluminescentes ;
une région 14 dopée du premier type de conductivité ou d'un deuxième type de conductivité, opposé au premier type, plus fortement dopée que le substrat 10, s'étendant dans le substrat 10 depuis la face 12 et jouant le rôle d'une première électrode ;
des plots de germination 16 favorisant la croissance de fils et disposés sur la face 12 au contact de la région 14 ;
des fils 20 (cinq fils étant représentés) de hauteur H₁, chaque fil 20 étant en contact avec l'un des plots de germination 16, chaque fil 20 comprenant une portion inférieure 22, de hauteur H₂, en contact avec le plot de germination 16 et une portion supérieure 24, de hauteur H₃, prolongeant la portion inférieure 22 ;
une couche isolante 26 s'étendant sur la face 12 du substrat 10 et sur les flancs latéraux de la portion inférieure 22 de chaque fil 20 ;
une coque 28 comprenant un empilement de couches semiconductrices recouvrant chaque portion supérieure 24 ;
une couche 30 formant une deuxième électrode recouvrant chaque coque 28 et s'étendant, en outre, sur la couche isolante 26 ;
une couche conductrice 32 recouvrant la couche d'électrode 30 entre les fils 20 mais ne s'étendant pas sur les fils 20 ;
une ouverture 34 dans la couche isolante 26 exposant la région 14 ;
un plot 36 d'un matériau conducteur s'étendant dans l'ouverture 34 et sur la couche isolante 26 autour de l'ouverture 34, le plot 36 étant en contact avec la région 14 dans l'ouverture 34 ; et
une couche d'encapsulation 38 recouvrant l'ensemble de la structure et notamment l'électrode 30.

Le dispositif optoélectronique 5 peut, en outre, comprendre une couche de luminophores, non représentée, prévue sur la couche d'encapsulation 38 ou confondue avec celle-ci.

L'ensemble formé par chaque fil 20, le plot de germination 16 et la coque 28 associés constitue une diode électroluminescente DEL. La base de la diode DEL correspond au plot de germination 16. La coque 28 comprend notamment une couche active qui est la couche depuis laquelle est émise la majorité du rayonnement électromagnétique fourni par la diode électroluminescente DEL. Les diodes électroluminescentes DEL sont connectées en parallèle et forment un ensemble A de diodes électroluminescentes. L'ensemble A peut comprendre de quelques diodes électroluminescentes DEL à un millier de diodes électroluminescentes.

Dans le présent mode de réalisation, le substrat semiconducteur 10 correspond à une structure monolithique. Le substrat 10 semiconducteur est, par exemple, un substrat en silicium, en germanium, en carbure de silicium, en un composé III-V, tel que du GaN ou du GaAs, ou un substrat en ZnO. De préférence, le substrat 10 est un substrat de silicium monocristallin.

Le substrat 10 est un substrat non dopé ou faiblement dopé avec une concentration de dopants inférieure ou égale à 5*10¹⁶ atomes/cm³, de préférence sensiblement égale à 10¹⁵ atomes/cm³. Le substrat 10 a une épaisseur comprise entre 275 µm et 1,5 mm, de préférence 725 µm.

Dans le cas d'un substrat 10 de silicium, des exemples de dopants de type P sont le bore (B) ou l'indium (In) et des exemples de dopants de type N sont le phosphore (P), l'arsenic (As), ou l'antimoine (Sb). De préférence, le substrat 10 est dopé de type P au Bore.

La face 12 du substrat 10 de silicium peut être une face (100) .

La région 14 est une région fortement dopée. De préférence, le type de conductivité de la région 14 est opposé au type de conductivité du substrat 10. A titre d'exemple, en figure 1, on a représenté un substrat 10 faiblement dopé de type P et une région 14 fortement dopée de type N. La concentration de dopants de la région 14 est comprise entre 5*10¹⁶ atomes/cm³ et 2*10²⁰ atomes/cm³, de préférence entre 3*10¹⁷ atomes/cm³ et 5*10¹⁸ atomes/cm³. L'épaisseur de la région 14 est comprise entre 150 nm et plusieurs micromètres, de préférence entre 150 nm et 1 µm, plus préférentiellement entre 150 nm et 400 nm.

Les plots de germination 16, appelés également îlots de germination, sont en un matériau favorisant la croissance des fils 20. Un traitement peut être prévu pour protéger les flancs latéraux des plots de germination et la surface des parties du substrat non recouvertes par les plots de germination pour empêcher la croissance des fils sur les flancs latéraux des plots de germination et sur la surface des parties du substrat non recouvertes par les plots de germination. Le traitement peut comprendre la formation d'une région diélectrique sur les flancs latéraux des plots de germination et s'étendant sur et/ou dans le substrat et reliant, pour chaque paire de plots, l'un des plots de la paire à l'autre plot de la paire, les fils ne croissant pas sur la région diélectrique. A titre de variante, les plots de germination 16 peuvent être remplacés par une couche de germination recouvrant la face 12 du substrat 10 et s'étendant sur la région 14. Une région diélectrique peut alors être formée au-dessus de la couche de germination pour empêcher la croissance de fils dans les zones non voulues.

A titre d'exemple, le matériau composant les plots de germination 16 peut être un nitrure, un carbure ou un borure d'un métal de transition de la colonne IV, V ou VI du tableau périodique des éléments ou une combinaison de ces composés. A titre d'exemple, les plots de germination 16 peuvent être en nitrure d'aluminium (AIN), en bore (B), en nitrure de bore (BN), en titane (Ti), en nitrure de titane (TiN), en tantale (Ta), en nitrure de tantale (TaN), en hafnium (Hf), en nitrure d'hafnium (HfN), en niobium (Nb), en nitrure de niobium (NbN), en zirconium (Zr), en borate de zirconium (ZrB₂), en nitrure de zirconium (ZrN), en carbure de silicium (SiC), en nitrure et carbure de tantale (TaCN), en nitrure de magnésium sous la forme MgₓN_{y}, où x est environ égal à 3 et y est environ égal à 2, par exemple du nitrure de magnésium selon la forme Mg₃N₂ ou du nitrure de gallium et de magnésium (MgGaN), en tungstène (W), en nitrure de tungstène (WN) ou en une combinaison de ceux-ci.

Les plots de germination 16 peuvent être dopés du même type de conductivité que la région 14.

La couche isolante 26 peut être en un matériau diélectrique, par exemple en oxyde de silicium (SiO₂), en nitrure de silicium (SiₓN_{y}, où x est environ égal à 3 et y est environ égal à 4, par exemple du Si₃N₄), en oxynitrure de silicium (SiOₓN_{y} où x peut être environ égal à 1/2 et y peut être environ égal à 1, par exemple du Si₂ON₂), en oxyde d'aluminium (Al₂O₃), en oxyde d'hafnium (HfO₂) ou en diamant. A titre d'exemple, l'épaisseur de la couche isolante 26 est comprise entre 5 nm et 800 nm, par exemple égale à environ 30 nm.

Les fils 20 sont, au moins en partie, formés à partir d'au moins un matériau semiconducteur. Le matériau semiconducteur peut être du silicium, du germanium, du carbure de silicium, un composé III-V, un composé II-VI ou une combinaison de ces composés.

Les fils 20 peuvent être, au moins en partie, formés à partir de matériaux semiconducteurs comportant majoritairement un composé III-V, par exemple des composés III-N. Des exemples d'éléments du groupe III comprennent le gallium (Ga), l'indium (In) ou l'aluminium (Al). Des exemples de composés III-N sont GaN, AlN, InN, InGaN, AlGaN ou AlInGaN. D'autres éléments du groupe V peuvent également être utilisés, par exemple, le phosphore ou l'arsenic. De façon générale, les éléments dans le composé III-V peuvent être combinés avec différentes fractions molaires.

Les fils 20 peuvent être, au moins en partie, formés à partir de matériaux semiconducteurs comportant majoritairement un composé II-VI. Des exemples d'éléments du groupe II comprennent des éléments du groupe IIA, notamment le béryllium (Be) et le magnésium (Mg) et des éléments du groupe IIB, notamment le zinc (Zn) et le cadmium (Cd). Des exemples d'éléments du groupe VI comprennent des éléments du groupe VIA, notamment l'oxygène (O) et le tellure (Te). Des exemples de composés II-VI sont ZnO, ZnMgO, CdZnO ou CdZnMgO. De façon générale, les éléments dans le composé II-VI peuvent être combinés avec différentes fractions molaires.

Les fils 20 peuvent comprendre un dopant. A titre d'exemple, pour des composés III-V, le dopant peut être choisi parmi le groupe comprenant un dopant de type P du groupe II, par exemple, du magnésium (Mg), du zinc (Zn), du cadmium (Cd) ou du mercure (Hg), un dopant du type P du groupe IV, par exemple du carbone (C) ou un dopant de type N du groupe IV, par exemple du silicium (Si), du germanium (Ge), du sélénium (Se), du souffre (S), du terbium (Tb) ou de l'étain (Sn).

La section droite des fils 20 peut avoir différentes formes, telles que, par exemple, une forme ovale, circulaire ou polygonale, notamment triangulaire, rectangulaire, carrée ou hexagonale. Ainsi, on comprend que, quand on mentionne ici le "diamètre" dans une section droite d'un fil ou d'une couche déposée sur ce fil, il s'agit d'une grandeur associée à la surface de la structure visée dans cette section droite, correspondant, par exemple, au diamètre du disque ayant la même surface que la section droite du fil. Le diamètre moyen de chaque fil 20 peut être compris entre 50 nm et 2,5 µm. La hauteur H₁ de chaque fil 20 peut être comprise entre 250 nm et 50 µm. Chaque fil 20 peut avoir une structure semiconductrice allongée selon un axe sensiblement perpendiculaire à la face 12. Chaque fil 20 peut avoir une forme générale cylindrique. Les axes de deux fils 20 adjacents peuvent être distants de 0,5 µm à 10 µm et de préférence de 1,5 µm à 4 µm. A titre d'exemple, les fils 20 peuvent être régulièrement répartis, notamment selon un réseau hexagonal.

A titre d'exemple, la portion inférieure 22 de chaque fil 20 est principalement constituée du composé III-N, par exemple du nitrure de gallium, dopé du même type que la région 14, par exemple de type N, par exemple au silicium. La portion inférieure 22 s'étend sur une hauteur H₂ qui peut être comprise entre 100 nm et 25 µm.

A titre d'exemple, la portion supérieure 24 de chaque fil 20 est au moins partiellement réalisée dans un composé III-N, par exemple du GaN. La portion supérieure 24 peut être dopée de type N, éventuellement moins fortement dopée que la portion inférieure 22, ou ne pas être intentionnellement dopée. La portion supérieure 24 s'étend sur une hauteur H₃ qui peut être comprise entre 100 nm et 25 µm.

La coque 28 peut comprendre un empilement de plusieurs couches comprenant notamment :
- une couche active recouvrant la portion supérieure 24 du fil 20 associé ;
- une couche intermédiaire de type de conductivité opposé à la portion inférieure 22 recouvrant la couche active ; et
- une couche de liaison recouvrant la couche intermédiaire et recouverte par l'électrode 30.

La couche active est la couche depuis laquelle est émise la majorité du rayonnement fourni par la diode électroluminescente DEL. Selon un exemple, la couche active peut comporter des moyens de confinement, tels que des puits quantiques multiples. Elle est, par exemple, constituée d'une alternance de couches de GaN et de InGaN ayant des épaisseurs respectives de 5 à 20 nm (par exemple 8 nm) et de 1 à 10 nm (par exemple 2,5 nm). Les couches de GaN peuvent être dopées, par exemple de type N ou P. Selon un autre exemple, la couche active peut comprendre une seule couche d'InGaN, par exemple d'épaisseur supérieure à 10 nm.

La couche intermédiaire, par exemple dopée de type P, peut correspondre à une couche semiconductrice ou à un empilement de couches semiconductrices et permet la formation d'une jonction P-N ou P-I-N, la couche active étant comprise entre la couche intermédiaire de type P et la portion supérieure 24 de type N de la jonction P-N ou P-I-N.

La couche de liaison peut correspondre à une couche semiconductrice ou à un empilement de couches semiconductrices et permet la formation d'un contact ohmique entre la couche intermédiaire et l'électrode 30. A titre d'exemple, la couche de liaison peut être dopée très fortement du type opposé à la portion inférieure 22 de chaque fil 20, jusqu'à dégénérer la ou les couches semiconductrices, par exemple dopée de type P à une concentration supérieure ou égale à 10²⁰ atomes/cm³.

L'empilement de couches semiconductrices peut comprendre une couche de blocage d'électrons formée d'un alliage ternaire, par exemple en nitrure de gallium et d'aluminium (AlGaN) ou en nitrure d'indium et d'aluminium (AlInN) en contact avec la couche active et la couche intermédiaire, pour assurer une bonne répartition des porteurs électriques dans la couche active.

L'électrode 30 est adaptée à polariser la couche active de chaque fil 20 et à laisser passer le rayonnement électromagnétique émis par les diodes électroluminescentes DEL. Le matériau formant l'électrode 30 peut être un matériau transparent et conducteur tel que de l'oxyde d'indium-étain (ou ITO, acronyme anglais pour Indium Tin Oxide), de l'oxyde de zinc dopé à l'aluminium ou du graphène. A titre d'exemple, la couche d'électrode 30 a une épaisseur comprise entre 5 nm et 200 nm, de préférence entre 20 nm et 50 nm.

La couche conductrice 32 correspond, de préférence à une couche métallique, par exemple en aluminium, en argent, en cuivre ou en zinc. A titre d'exemple, la couche conductrice 32 a une épaisseur comprise entre 20 nm et 1000 nm, de préférence entre 100 nm et 200 nm.

La couche d'encapsulation 38 est réalisée en un matériau isolant au moins partiellement transparent. L'épaisseur maximale de la couche d'encapsulation 38 est comprise entre 250 nm et 50 µm de sorte que la couche d'encapsulation 38 recouvre complètement l'électrode 30 au sommet des diodes électroluminescentes DEL. La couche d'encapsulation 38 peut être réalisée en un matériau inorganique au moins partiellement transparent. Selon un exemple, la couche d'encapsulation 38 est en silicone. Selon un autre exemple, le matériau inorganique est choisi parmi le groupe comprenant les oxydes de silicium du type SiOₓ où x est un nombre réel compris entre 0 et 2, ou SiO_{y}N_{z} où y est un nombre réel compris entre 0 et 2 et z est compris entre 0 et 1 et les oxydes d'aluminium, par exemple Al₂O₃. La couche d'encapsulation 38 peut être réalisée en un matériau organique au moins partiellement transparent. A titre d'exemple, la couche d'encapsulation 38 est un polymère époxyde.

La polarisation de chaque diode électroluminescente DEL de l'ensemble A est obtenue en reliant l'électrode 30 à une source V1 d'un premier potentiel de référence et en reliant le plot 36 à une source V2 d'un deuxième potentiel de référence. A titre d'exemple, dans le cas de fil dopé de type N, le premier potentiel peut être supérieur au deuxième potentiel et la source V2 peut correspondre à la masse.

De préférence, plusieurs dispositifs optoélectroniques à diodes électroluminescentes sont formés simultanément sur une plaque d'un substrat semiconducteur. Le nombre de diodes électroluminescentes peut être différent selon les dispositifs optoélectroniques. La séparation des dispositifs optoélectroniques est réalisée par des étapes de découpe de la plaque. De façon avantageuse, il s'agit d'une plaque de silicium habituellement utilisée dans les procédés de fabrication de circuits en microélectronique, notamment à base de transistors à effet de champ à grille métal-oxyde ou transistors MOS.

Un mode de réalisation d'un procédé de fabrication permettant l'obtention du dispositif optoélectronique 5 comprend les étapes suivantes :
(1) Formation de la région 14. La région 14 peut être obtenue par une ou plus d'une implantation de dopants dans le substrat 10 ou par croissance par une épitaxie sélective du matériau fortement dopé sur un support initial.
(2) Formation sur la face 12 du substrat 10 des plots de germination 16.

Les plots de germination 16 peuvent être obtenus par le dépôt d'une couche de germination sur la face 12 et par la gravure de portions de la couche de germination jusqu'à la face 12 du substrat 10 pour délimiter les plots de germination. La couche de germination peut être déposée par un procédé du type dépôt chimique en phase vapeur (CVD, sigle anglais pour Chemical Vapor Deposition) ou dépôt chimique en phase vapeur organométallique (MOCVD, acronyme anglais pour Metal-Organic Chemical Vapor Déposition), également connu sous le nom d'épitaxie organométallique en phase vapeur (ou MOVPE, acronyme anglais pour Metal-Organic Vapor Phase Epitaxy). Toutefois, des procédés tels que l'épitaxie par jets moléculaires (MBE, acronyme anglais pour Molecular-Beam Epitaxy), la MBE à source de gaz (GSMBE), la MBE organométallique (MOMBE), la MBE assistée par plasma (PAMBE), l'épitaxie par couche atomique (ALE, acronyme anglais pour Atomic Layer Epitaxy), l'épitaxie en phase vapeur aux hydrures (HVPE, acronyme anglais pour Hydride Vapor Phase Epitaxy) peuvent être utilisés ou un procédé de dépôt de couche mince atomique (ALD, acronyme anglais pour Atomic Layer Déposition). En outre, des procédés tels l'évaporation ou la pulvérisation cathodique réactive peuvent être utilisés.

Lorsque les plots de germination 16 sont en nitrure d'aluminium, ils peuvent être sensiblement texturés et posséder une polarité préférentielle. La texturation des plots 16 peut être obtenue par un traitement supplémentaire réalisé après le dépôt de la couche de germination. Il s'agit, par exemple, d'un recuit sous flux d'ammoniac (NH₃).
(3) Protection des portions de la face 12 du substrat 10 non recouvertes des plots de germination 16 pour éviter la croissance ultérieure de fils sur ces portions. Ceci peut être obtenu par une étape de nitruration qui entraîne la formation, en surface du substrat 10, entre les plots de germination 16, de régions de nitrure de silicium (par exemple SiN ou Si₃N₄). Ceci peut également être obtenu par une étape de masquage du substrat 10 entre les plots de germination 16, incluant le dépôt d'une couche par exemple d'un diélectrique SiO₂ ou SiN ou Si₃N₄ puis la gravure de cette couche hors des plots de germination 16 après une étape de photolithographie. Dans ce cas, la couche de masquage peut déborder au-dessus des plots de germination 16. Lorsque l'étape de protection (3) est réalisée par une étape de masquage du substrat 10, l'étape de gravure de la couche de germination peut être évitée. Les plots de germination 16 sont alors constitués d'une couche continue uniforme et dont la surface est laissée libre au niveau où les fils croissent.
(4) Croissance de la portion inférieure 22 de chaque fil 26 sur la hauteur H₂. Chaque fil 26 croît depuis le sommet du plot de germination 16 sous-jacent.

Le procédé de croissance des fils 26 peut être un procédé du type CVD, MOCVD, MBE, GSMBE, PAMBE, ALE, HVPE, ALD. En outre, des procédés électrochimiques peuvent être utilisés, par exemple, le dépôt en bain chimique (CBD, sigle anglais pour Chemical Bath Déposition), les procédés hydrothermiques, la pyrolyse d'aérosol liquide ou l'électrodépôt.

A titre d'exemple, le procédé de croissance des fils peut comprendre l'injection dans un réacteur d'un précurseur d'un élément du groupe III et d'un précurseur d'un élément du groupe V. Des exemples de précurseurs d'éléments du groupe III sont le triméthylgallium (TMGa), le triéthylgallium (TEGa), le triméthylindium (TMIn) ou le triméthylaluminium (TMAl). Des exemples de précurseurs d'éléments du groupe V sont l'ammoniac (NH₃), le tertiarybutylphosphine (TBP), l'arsine (AsH₃), ou le diméthylhydrazine asymétrique (UDMH).

Selon un mode de réalisation de l'invention, dans une première phase de croissance des fils du composé III-V, un précurseur d'un élément supplémentaire est ajouté en excès en plus des précurseurs du composé III-V. L'élément supplémentaire peut être le silicium (Si). Un exemple de précurseur du silicium est le silane (SiH₄).

La présence de silane parmi les gaz précurseurs entraîne l'incorporation de silicium au sein du composé GaN. On obtient ainsi une portion inférieure 22 dopée de type N. En outre, ceci se traduit par la formation d'une couche de nitrure de silicium, non représentée, qui recouvre le pourtour de la portion 22 de hauteur H₂, à l'exception du sommet au fur et à mesure de la croissance de la portion 22.
(5) Croissance de la portion supérieure 24 de hauteur H₃ de chaque fil 20 sur le sommet de la portion inférieure 22. Pour la croissance de la portion supérieure 24, les conditions de fonctionnement du réacteur MOCVD décrites précédemment sont, à titre d'exemple, maintenues à l'exception du fait que le flux de silane dans le réacteur est réduit, par exemple d'un facteur supérieur ou égal à 10, ou arrêté. Même lorsque le flux de silane est arrêté, la portion supérieure 24 peut être dopée de type N en raison de la diffusion dans cette portion active de dopants provenant des portions passivées adjacentes ou en raison du dopage résiduel du GaN.
(6) Formation par épitaxie, pour chaque fil 20, des couches composant la coque 28. Compte tenu de la présence de la couche de nitrure de silicium recouvrant le pourtour de la portion inférieure 22, le dépôt des couches composant la coque 28 ne se produit que sur la portion supérieure 24 du fil 20 non recouverte par la couche de nitrure de silicium.
(7) Formation de la couche isolante 26, par exemple par dépôt conforme d'une couche isolante sur la totalité de la structure obtenue à l'étape (6) et gravure de cette couche pour exposer la coque 28 de chaque fil 20. Dans le mode de réalisation décrit précédemment, la couche isolante 26 ne recouvre pas la coque 28. A titre de variante, la couche isolante 26 peut recouvrir une partie de coque 28. En outre, la couche isolante 26 peut être réalisée avant la formation de la coque 28.
(8) Formation de l'électrode 30, par exemple par dépôt conforme.
(9) Formation de la couche conductrice 32 par exemple par dépôt physique en phase vapeur (PVD, acronyme anglais pour Physical Vapor Déposition) sur l'ensemble de la structure obtenue à l'étape (8) ou par exemple par évaporation ou par pulvérisation cathodique et gravure de cette couche pour exposer chaque fil 20 ;
(10) Formation de la couche d'encapsulation 38. Lorsque la couche d'encapsulation 38 est en silicone, la couche d'encapsulation 38 peut être déposée par un procédé de dépôt à la tournette, par un procédé d'impression par jet ou par un procédé de sérigraphie. Lorsque la couche d'encapsulation 38 est un oxyde, elle peut être déposée par CVD ; et
(11) Découpe du substrat 10 pour séparer les dispositifs optoélectroniques.

Dans le mode de réalisation décrit précédemment, la région 14 est formée avant les fils 20. A titre de variante, la région 14 peut être formée, notamment par implantation, après les fils 20.

La figure 2 est une coupe, partielle et schématique, d'un dispositif optoélectronique 40 selon un autre mode de réalisation. Le dispositif optoélectronique 40 comprend l'ensemble des éléments du dispositif optoélectronique 5 représenté en figure 1 à la différence que le substrat monolithique 10 correspond à une structure multicouche du type silicium sur isolant ou SOI (acronyme anglais pour Silicon On Insulator). Le substrat 10 comprend une couche 44 d'un matériau semiconducteur séparée d'un support 46 par une couche isolante 48. La face 12 correspond à la face supérieure de la couche semiconductrice 44.

La couche semiconductrice 44 peut être réalisée avec le même matériau que le substrat 10. En particulier, la couche semiconductrice 44 est faiblement dopée. A titre d'exemple, l'épaisseur de la couche semiconductrice 44 est comprise entre 10 nm et 1 µm. La couche isolante 48 correspond, par exemple, à un oxyde ou à un nitrure. A titre d'exemple, l'épaisseur de la couche isolante 48 est comprise entre 10 nm et 300 nm. Le support 46 peut être un matériau semiconducteur ou isolant. Lorsque le support 46 correspond à un matériau isolant, la couche isolante 48 et le support 46 peuvent être confondus.

La région 14 s'étend dans la couche semiconductrice 44 depuis la face 12, par exemple sur la totalité de l'épaisseur de la couche semiconductrice 44. Le dispositif optoélectronique 40 présente l'avantage, par rapport au dispositif optoélectronique 5, de supprimer les courants de fuite de la région 14 vers le support 46.

La figure 3 est une coupe, partielle et schématique, d'un dispositif optoélectronique 50 selon un autre mode de réalisation. Le dispositif optoélectronique 50 comprend l'ensemble des éléments du dispositif optoélectronique 5 représenté en figure 1 et comprend, en outre, des régions isolantes 52, s'étendant au moins en partie dans le substrat 10 au moins en partie autour de la région fortement dopée 14. Bien que cela ne soit pas représenté en figure 3, les régions isolantes 52 peuvent, en outre, se projeter en saillie par rapport à la face 12.

Chaque région isolante 52 peut s'étendre dans le substrat 10 depuis la face 12 sur une profondeur comprise entre 60 nm et 800 nm, de préférence 150 nm. A titre d'exemple, les régions isolantes 52 sont réalisées en oxyde de silicium ou en nitrure de silicium. Les régions isolantes 52 peuvent être réalisées par un procédé de formation de tranchées d'isolation du type STI (acronyme anglais pour "Shallow Trench Isolation"). Le dispositif optoélectronique 50 présente l'avantage, par rapport au dispositif optoélectronique 5, de supprimer les courants de fuite latéraux depuis la région 14.

La figure 4 est une coupe, partielle et schématique, d'un dispositif optoélectronique 54 comprenant à la fois la couche isolante 48 du dispositif optoélectronique 40 représenté en figure 2 et les régions isolantes 52 du dispositif optoélectronique 50 représenté en figure 3. Le dispositif optoélectronique 54 présente l'avantage, par rapport au dispositif optoélectronique 5, de supprimer les courants de fuites latéraux depuis la région 14 et les courants de fuites de la région 14 vers le support 46.

La polarisation de la base des diodes électroluminescentes DEL est réalisée par la région fortement dopée 14 qui peut être isolée électriquement du reste du substrat 10. Plusieurs régions fortement dopées peuvent donc être réalisées dans le substrat 10, ces régions fortement dopées étant associées à des ensembles distincts de diodes électroluminescentes.

La figure 5 est une vue en coupe d'un dispositif optoélectronique 60 qui comprend deux ensembles A1, A2 de diodes électroluminescentes DEL. Chaque ensemble A1, A2 de diodes électroluminescentes peut avoir la même structure que celle représentée en figure 1. En figure 5, on ajoute l'indice "1" aux références des éléments associés à l'ensemble A1 et l'indice "2" aux références des éléments associés à l'ensemble A2. En particulier, les bases des diodes électroluminescentes de chaque ensemble A1, A2 sont au contact d'une région fortement dopée 14. La région fortement dopée 14₁ associée à l'ensemble A1 de diodes électroluminescentes est séparée par la région fortement dopée 14₂ associée à l'ensemble A2 de diodes électroluminescentes par une portion 66 faiblement dopée du substrat 10. De préférence, la distance minimale séparant les deux régions 14₁, 14₂ fortement dopées adjacentes est supérieure à 2 µm, de préférence comprise entre 2 µm et 10 µm.

Dans le présent mode de réalisation, l'ensemble A1 de diodes électroluminescentes est connecté en série avec l'ensemble A2 de diodes électroluminescentes. Dans ce but, l'électrode 30₂ et la couche conductrice 32₂ de l'ensemble A2 de diodes électroluminescentes DEL₂ s'étendent jusqu'à l'ouverture 34₁ pour former le plot de contact 36₁ de l'ensemble A1 et venir au contact de la région fortement dopée 14₁ de l'ensemble A1.

L'électrode 30₁ de l'ensemble A1 de diodes électroluminescentes est reliée à la source V1 du second potentiel de référence et le plot de contact 36₂ de l'ensemble A2 de diodes électroluminescentes est relié à la source V2 du premier potentiel de référence.

En figure 5, on a représenté un dispositif optoélectronique 60 comprenant deux ensembles A1, A2 de diodes électroluminescentes disposés en série. Le nombre d'ensembles de diodes électroluminescentes disposés en série peut être plus important. Le dispositif optoélectronique 60 peut comprendre de 2 à plus de 100 ensembles de diodes électroluminescentes disposés en série. L'association d'ensembles de diodes électroluminescentes montés en série permet d'augmenter l'amplitude maximale de la tension d'alimentation appliquée aux ensembles de diodes électroluminescentes qui est égale à la différence entre les premier et deuxième potentiels de référence fournis par les sources V1, V2. A titre d'exemple, la tension d'alimentation peut avoir une amplitude maximale supérieure ou égale à 6 V, par exemple d'environ 12 V, 24 V, 48 V, 110 V ou 240 V.

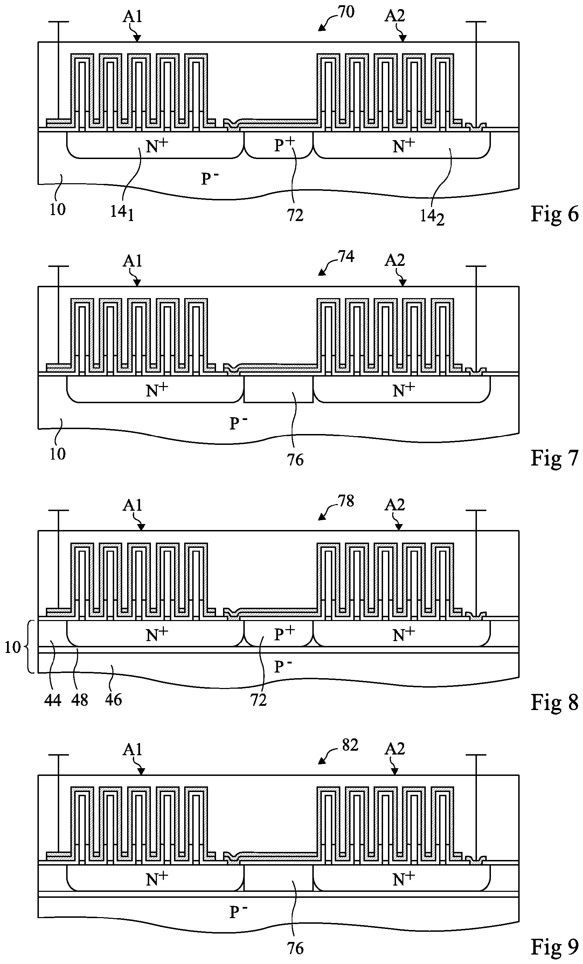

La figure 6 est une vue en coupe d'un dispositif optoélectronique 70 selon un autre mode de réalisation. Le dispositif optoélectronique 70 comprend l'ensemble des éléments du dispositif optoélectronique 60 représenté en figure 5 et comprend, en outre, une région 72 fortement dopée s'étendant dans le substrat 10 depuis la face 12 et disposée entre la région fortement dopée 14₁ associée à l'ensemble A1 et la région fortement dopée 14₂ associée à l'ensemble A2. La région fortement dopée 72 est de type de conductivité opposé aux régions fortement dopées 14₁, 14₂. La concentration de dopants de la région 72 est comprise entre 5*10¹⁶ atomes/cm³ et 2*10²⁰ atomes/cm³, de préférence entre 3*10¹⁷ atomes/cm³ et 5*10¹⁸ atomes/cm³. La région 72 permet d'améliorer l'isolation électrique entre les régions 14₁, 14₂.

La figure 7 est une vue en coupe d'un dispositif optoélectronique 74 selon un autre mode de réalisation. Le dispositif optoélectronique 74 comprend l'ensemble des éléments du dispositif optoélectronique 72 représenté en figure 6 à la différence que la région fortement dopée 72 est remplacée par une région isolante 76 qui peut être identique à la région isolante 52 décrite précédemment.

La figure 8 est une vue en coupe d'un dispositif optoélectronique 78 selon un autre mode de réalisation. Le dispositif optoélectronique 78 comprend l'ensemble des éléments du dispositif optoélectronique 72 à la différence que le substrat 10 a une structure de type SOI décrite précédemment. A titre de variante, la région fortement dopée 72 de type P peut ne pas être présente, les régions 14 étant séparées par une portion faiblement dopée de la couche semiconductrice 44.

La figure 9 est une vue en coupe d'un dispositif optoélectronique 82 selon un autre mode de réalisation. Le dispositif optoélectronique 82 comprend l'ensemble des éléments du dispositif optoélectronique 78 à la différence que la région fortement dopée 72 est remplacée par la région isolante 76 décrite précédemment.

En plus d'un ou de plusieurs ensembles de diodes électroluminescentes, le dispositif optoélectronique peut comprendre des composants électroniques supplémentaires, notamment des diodes, des diodes Zener, des diodes en avalanche, des transistors MOS et/ou des transistors bipolaires, des résistances, des capacités métal-oxyde-semiconducteur, également appelées capacités MOS, des capacités métal-isolant-métal, également appelées capacités MIM, des thyristors, des varacteurs, des mémoires volatiles, par exemple des mémoires dynamiques à accès aléatoire appelées DRAM, des mémoires non volatiles, par exemple des mémoires flash.

Selon un mode de réalisation, les composants électroniques supplémentaires intégrés au substrat 10 sur lequel sont formées les diodes électroluminescentes sont utilisés pour réaliser un circuit de protection des diodes électroluminescentes contre les décharges électrostatiques, appelées également ESD (acronyme anglais pour Electrostatic Discharge).

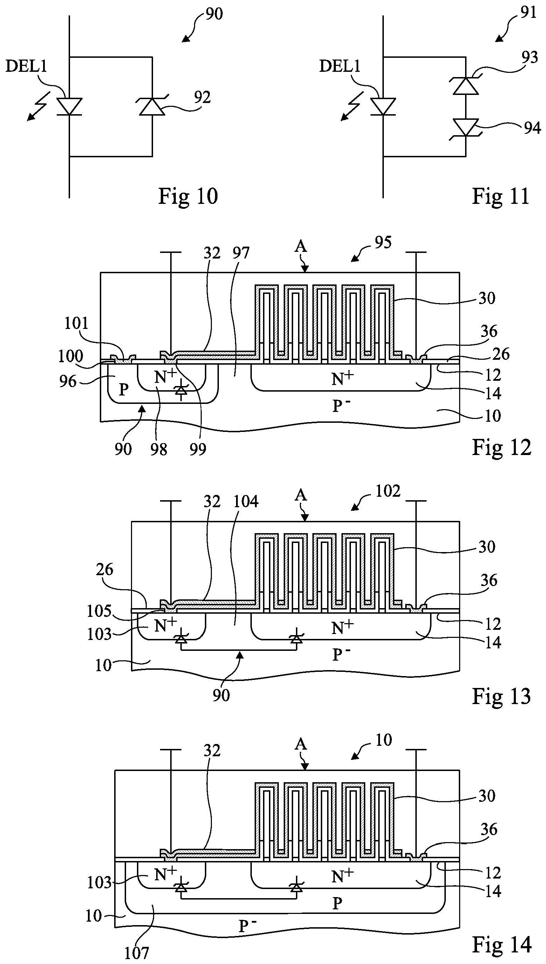

Les figures 10 et 11 représentent des exemples de circuits 90, 91 de protection d'une diode électroluminescente DEL1 contre les décharges électrostatiques. La diode électroluminescente DEL1 peut correspondre à un ensemble de diodes électroluminescentes montées en parallèle tel que représenté en figure 1. La diode électroluminescente DEL1 peut correspondre à un ensemble de diodes électroluminescentes montées en série tel que représenté aux figures 5 à 9. Le circuit de protection 90, 91 est monté en parallèle sur les bornes de la diode électroluminescente DEL1. Le circuit de protection 90, 91 fournit un passage privilégié pour le courant lorsqu'une surtension est appliquée aux bornes de la diode électroluminescente DEL1. En figure 10, le circuit de protection 90 comprend une diode Zener 92 dont l'anode est reliée à la cathode de la diode électroluminescente DEL1 et dont la cathode est reliée à l'anode de la diode électroluminescente DEL1. En figure 11, le circuit de protection 91 comprend deux diodes Zener 93, 94 montées tête-bêche, les anodes des diodes Zener 93, 94 étant connectées l'une à l'autre comme cela est représenté en figure 11, ou à titre de variante, les cathodes des diodes Zener étant connectées l'une à l'autre. A titre de variante, les circuits de protection 90, 91 peuvent comporter une ou plus d'une diode en avalanche.

La figure 12 représente un dispositif optoélectronique 95 comprenant un ensemble A de diodes électroluminescentes tel que représenté en figure 1 et comprenant, en outre, un circuit de protection 90 tel que représenté en figure 10. Le dispositif optoélectronique 95 comprend une région fortement dopée 96 du type de conductivité opposé à la région 14 et séparée de la région 14 par une portion 97 faiblement dopée du substrat 10. La région 96 s'étend dans le substrat 10 depuis la face 12. Le dispositif optoélectronique 95 comprend une région fortement dopée 98 du même type de conductivité que la région 14 et s'étendant dans la région 96 depuis la face 12. La région 96 s'étend plus profondément dans le substrat 10 que la région 98.

Une ouverture 99 est prévue dans la couche isolante 26 pour exposer une partie de la région 98. L'électrode 30 et la couche conductrice 32 s'étendent jusqu'à l'ouverture 99 pour venir au contact de la région fortement dopée 98 au travers de l'ouverture 99. Une ouverture 100 est prévue dans la couche isolante 26 pour exposer une partie de la région 96. Un plot conducteur 101 est prévu au contact de la région fortement dopée 96 au travers de l'ouverture 100. Le plot conducteur 101 est relié au plot conducteur 36 par des éléments conducteurs non représentés. La région 98 de type N forme avec la région 96 de type P la diode Zener du circuit de protection 90.

La figure 13 représente un dispositif optoélectronique 102 comprenant l'ensemble A de diodes électroluminescentes tel que représenté en figure 1 et comprenant, en outre, un circuit de protection 91 tel que représenté en figure 11. Le dispositif optoélectronique 102 comprend une région 103 fortement dopée du même type de conductivité que la région 14 et séparée de la région 14 par une portion 104 faiblement dopée du substrat 10. La région 103 s'étend dans le substrat 10 depuis la face 12. Une ouverture 105 est prévue dans la couche isolante 26 pour exposer une partie de la région 103. L'électrode 30 et la couche conductrice 32 s'étendent jusqu'à l'ouverture 105 pour venir au contact de la région fortement dopée 103 au travers de l'ouverture 105. Les régions 14 et 103 sont, par exemple, formées par les mêmes étapes d'implantation ionique ou les mêmes étapes d'épitaxie. Les régions 14 et 103 de type N forment avec le substrat 10 de type P les diodes Zener du circuit de protection 91.

La figure 14 représente un dispositif optoélectronique 106 comprenant l'ensemble des éléments du dispositif optoélectronique 102 représenté en figure 13 et comprenant, en outre, une région 107 dopée du type de conductivité opposé aux régions 14, s'étendant depuis la face 12, et plus fortement dopée que le substrat 10. Les régions 103 et 14 s'étendent dans la région 107. La région 107 s'étend plus profondément dans le substrat 10 que les régions 14 et 103. Les régions 14 et 103 de type N forment avec la région de type P les diodes Zener du circuit de protection 91.

Dans les modes de réalisation décrits précédemment, l'une ou plus d'une des régions 14, 96, 98, 103, 107 peuvent être obtenues par une étape ou plus d'une étape d'implantation de dopants dans le substrat 10 ou par croissance par une épitaxie sélective du matériau dopé sur un support initial. Dans le cas où ces régions 14, 96, 98, 103, 107 sont obtenues par une ou plusieurs étapes d'implantations de dopants dans le substrat, elles peuvent être réalisées avant ou après la formation des fils 20.

Selon un mode de réalisation, les composants électroniques supplémentaires intégrés au substrat 10 sur lequel sont formées les diodes électroluminescentes sont utilisés pour réaliser, au moins partiellement, un circuit de détection de la température des diodes électroluminescentes.

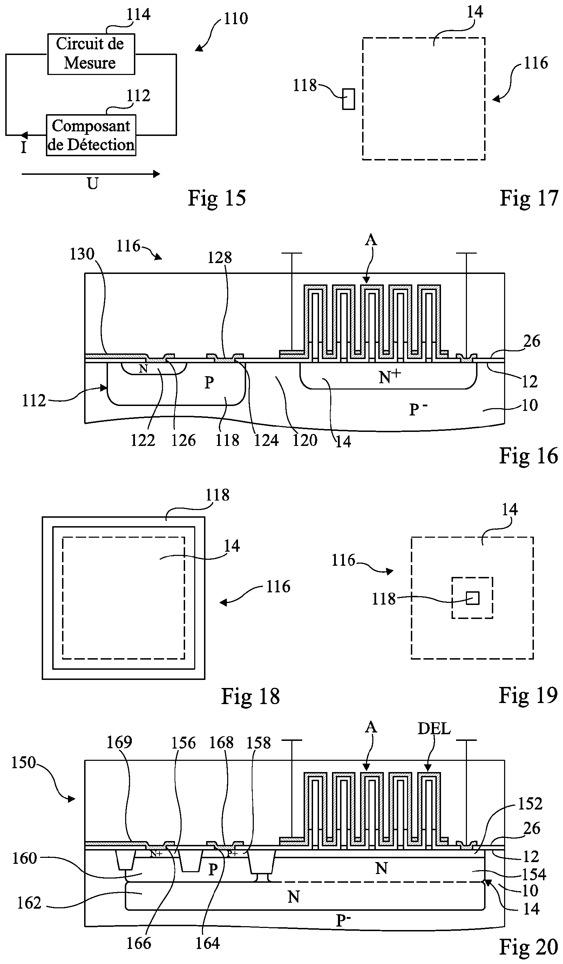

La figure 15 représente, de façon schématique, le principe de fonctionnement d'un circuit de détection de température. Le circuit 110 comprend un composant électronique 112 de détection et un circuit 114 de mesure de la tension U aux bornes du composant 112 et/ou du courant I traversant le composant 112. Les caractéristiques de fonctionnement du composant de détection 112 varient en fonction de la température de sorte que la tension U à courant I constant ou le courant I à tension U constante varie lorsque la température au voisinage du composant de détection 112 varie. Le composant de détection 112 peut comprendre au moins une diode ou au moins un transistor bipolaire dont la base et l'émetteur (ou le collecteur) sont reliés en commun.

Selon un mode de réalisation, au moins le composant de détection 112 est réalisé de façon intégrée au substrat 10 dans le voisinage de l'ensemble A de diodes électroluminescentes. Le circuit de mesure 114 peut être réalisé par un circuit électronique distinct du dispositif optoélectronique ou être réalisé, en tout ou en partie, de façon intégrée au substrat 10. Le composant de détection 112 étant situé à proximité des diodes électroluminescentes, notamment à moins d'une centaine de micromètres typiquement une dizaine de micromètres, la température mesurée par le circuit de mesure 114 est représentative de la température réelle au niveau de la couche active des diodes électroluminescentes. Ceci n'est pas le cas lorsque le composant de détection 112 fait partie d'un circuit qui est distinct du dispositif optoélectronique. En effet, le composant de détection 112 est alors situé à plusieurs centaines de micromètres des diodes électroluminescentes.

La figure 16 représente un dispositif optoélectronique 116 comprenant un ensemble A de diodes électroluminescentes tel que représenté en figure 1 et comprenant, en outre, un composant de détection de température 112. Le dispositif optoélectronique 116 comprend, en outre, une région fortement dopée 118 de type P, plus fortement dopée que le substrat 10, séparée de la région 14 par une portion 120 faiblement dopée du substrat 10. Le dispositif optoélectronique 116 comprend, en outre, une région 122 dopée de type N, s'étendant depuis la face 12 dans la région 118 de type P. Les régions 118 et 122 forment une jonction P-N qui constitue la diode de détection de température. Une ouverture 124 est prévue dans la couche isolante 26 pour exposer une partie de la région 118 et une ouverture 126 est prévue dans la couche isolante 26 pour exposer une partie de la région 122. Une piste conductrice 128 vient au contact de la région 118 au travers de l'ouverture 124 et une piste conductrice 130 vient au contact de la région 122 au travers de l'ouverture 126. A titre de variante, la région 118 peut être dopée de type N. Dans ce cas, la région 122 est dopée de type P. Le composant de détection de température 112 peut être isolé de l'ensemble A de diodes électroluminescentes par l'une des structures d'isolation décrites précédemment en relation avec les figures 6 à 9.

Les figures 17 à 19 représentent des vues de dessus schématiques du dispositif optoélectronique 116 dans lesquelles on a représenté le contour de la région 14 sur laquelle est formé l'ensemble A de diodes électroluminescentes par une ligne à tirets courts et dans lesquelles on a représenté le contour de la région 118 dans laquelle est formé le composant de détection 112 par une ligne continue.

En figure 17, le composant de détection 112 est disposé le long d'un bord de l'ensemble A de diodes électroluminescentes. En figure 18, le composant de détection 112 est disposé tout autour de l'ensemble A de diodes électroluminescentes. Le signal mesuré par le circuit de mesure 114 permet alors avantageusement la détermination de la température moyenne à la périphérie de l'ensemble A de diodes électroluminescentes. En figure 19, l'ensemble A de diodes électroluminescentes est disposé autour du composant de détection 112. Le capteur de température peut, par exemple, servir à la régulation du courant traversant les diodes électroluminescentes afin de ne pas dégrader leurs caractéristiques.

Selon un mode de réalisation, les composants électroniques supplémentaires intégrés au substrat 10 sur lequel sont formées les diodes électroluminescentes sont utilisés pour réaliser, au moins partiellement, un circuit de commande des diodes électroluminescentes.

A titre d'exemple, le circuit de commande peut comprendre un convertisseur de courant alternatif-continu recevant une tension alternative, correspondant par exemple à la tension alternative du secteur, et fournissant une tension continue qui peut par exemple être appliquée entre l'électrode 30 et la région 14. A titre d'exemple, le circuit de commande peut comprendre un redresseur de tension, un interrupteur (switch en anglais) ou un régulateur de courant qui peut par exemple comprendre un amplificateur opérationnel.

A titre d'exemple, le circuit de commande est un circuit de fourniture d'impulsions de courant ou de tension utilisées pour alimenter les diodes électroluminescentes. Ceci permet de réduire les effets d'échauffement des diodes électroluminescentes pour la même puissance moyenne consommée. La fréquence et la durée des impulsions sont déterminées pour qu'un observateur perçoive un signal lumineux continu en raison de la persistance rétinienne, par exemple en utilisant un modulateur de largeur d'impulsions (PWM, sigle anglais pour Pulse Width Modulation).

A titre d'exemple, le circuit de commande peut comprendre un module de protection thermique, qui est par exemple formé par un circuit de mesure de la température tel que décrit précédemment en relation avec les figures 15 à 19, associé à un circuit PWM fournissant des impulsions de tension ou de courant dont la durée étant modulée en fonction de la température mesurée, par exemple en utilisant une boucle de contre-réaction qui peut mettre en oeuvre un amplificateur opérationnel. A titre d'exemple, la durée des impulsions du signal électrique peut être diminuée quand la température mesurée dépasse une valeur prédéfinie, par exemple 125°C. Le circuit de protection thermique est, par exemple, formé par un circuit de mesure de la température, tel que décrit précédemment en relation avec les figures 15 à 19, associé à un interrupteur permettant de couper le signal électrique quand la température mesurée dépasse une valeur prédéfinie, par exemple 130°C. Le circuit de protection thermique est, par exemple, formé par un circuit de mesure de température, tel que décrit précédemment en relation avec les figures 15 à 19, associé à un régulateur de courant fournissant un courant dont l'intensité dépend de la mesure de la température.

Tout ou partie des composants électroniques, utilisés pour la réalisation du circuit de commande, peuvent être réalisés sur le même substrat 10 sur lequel sont formées les diodes électroluminescentes. Ces composants électroniques peuvent comprendre notamment des transistors bipolaires.

La figure 20 représente une vue en coupe d'un dispositif optoélectronique 150 comprenant un ensemble A de diodes électroluminescentes tel que représenté en figure 1 à la différence que la région 14 comprend une première région 152 dopée de type N qui s'étend depuis la face 12 et une deuxième région 154 dopée de type N, moins fortement dopée que la région 152 et plus fortement dopée que le substrat 10, et qui s'étend sous la région 152. Le dispositif optoélectronique 150 comprend, en outre, une région 156 fortement dopée de type N s'étendant dans le substrat 10 depuis la face 12 et une région 158 fortement dopée de type P s'étendant dans le substrat 10 depuis la face 12. Une région 160 dopée de type P s'étend sous les régions 156 et 158 et relie ces régions. La région 160 est moins fortement dopée que la région 158 et plus fortement dopée que le substrat 10. Une région 162 enterrée dopée de type N s'étend sous la région 160 et la région 154 et relie ces deux régions. Une ouverture 164 est prévue dans la couche isolante 26 pour exposer une partie de la région 158 et une ouverture 166 est prévue dans la couche isolante 26 pour exposer une partie de la région 156. Une piste conductrice 168 vient au contact de la région 158 au travers de l'ouverture 164 et une piste conductrice 169 vient au contact de la région 156 au travers de l'ouverture 166.

La région 156 forme l'émetteur ou le collecteur du transistor bipolaire et la région 158 forme la base du transistor bipolaire. La région 162 forme le collecteur ou l'émetteur du transistor bipolaire et est connectée, dans le présent mode de réalisation, à la cathode des diodes électroluminescentes DEL.

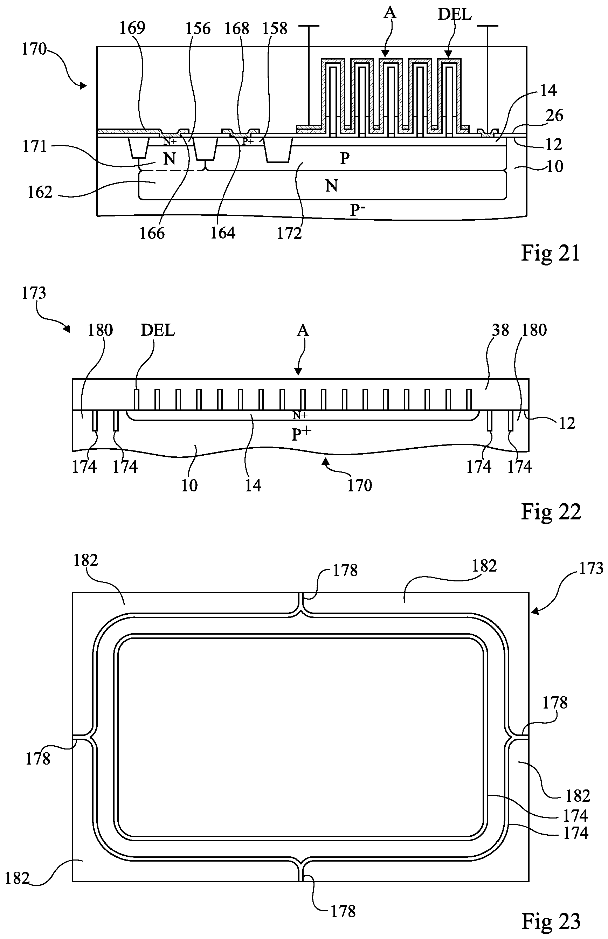

La figure 21 représente une vue en coupe d'un dispositif optoélectronique 170 comprenant l'ensemble des éléments du dispositif optoélectronique 150 représenté en figure 20 à la différence que les régions 160 et 154 sont remplacées par une région 171 dopée du même type de conductivité que la région 162 et s'étendant entre la région 156 et la région 162 et une région 172 dopée du même type de conductivité que la région 158 et s'étendant entre les régions 158, 14 et 162.

La région 156 forme l'émetteur ou le collecteur du transistor bipolaire et la région 158 forme la base du transistor bipolaire. La région 14 forme le collecteur ou l'émetteur du transistor bipolaire et est connectée, dans le présent mode de réalisation, à la cathode des diodes électroluminescentes DEL.

Dans le dispositif optoélectronique 150 représenté en figure 20, les jonctions P-N du transistor bipolaire sont situées sensiblement sous les régions 156 et 158 tandis que, dans le dispositif optoélectronique 170 représenté en figure 21, les jonctions P-N du transistor bipolaire sont situées principalement sous la région 14.

Les figures 22 et 23 sont respectivement une coupe et une vue de dessus d'un mode de réalisation d'un dispositif optoélectronique 173 à fils.

Le dispositif optoélectronique 173 comprend à sa périphérie deux tranchées 174 remplies d'un matériau isolant qui s'étendent sur une partie de l'épaisseur du substrat 10 depuis la face 12. A titre d'exemple, chaque tranchée a une largeur supérieure à 1 µm, par exemple d'environ 2 µm. La distance entre les deux tranchées 174 est supérieure à 5 µm, par exemple d'environ 6 µm. Les tranchées 174 permettent d'obtenir une isolation électrique latérale du dispositif optoélectronique 173.

Comme cela apparaît en figure 23, des tranchées supplémentaires 178 se projettent depuis la tranchée 174 périphérique externe jusqu'aux bords latéraux du dispositif optoélectronique 173. Après découpe, une portion 180 de substrat 10 subsiste à la périphérie de chaque dispositif optoélectronique 170, 172. Les tranchées 178 permettent de diviser cette portion 180 périphérique en plusieurs segments isolés 182. Ceci permet de réduire les risques de court-circuit dans le cas où des éléments conducteurs viendraient au contact de ces segments.

Des modes de réalisation particuliers de la présente invention ont été décrits. Diverses variantes et modifications apparaîtront à l'homme de l'art. De plus, bien que, dans les modes de réalisation décrits précédemment, chaque fil 20 comprenne une portion passivée 22, à la base du fil en contact avec l'un des plots de germination 16, cette portion passivée 22 peut ne pas être présente.

En outre, bien que des modes de réalisation aient été décrits pour un dispositif optoélectronique pour lequel la coque 28 recouvre le sommet du fil 20 associé et une partie des flancs latéraux du fil 20, la coque peut n'être prévue qu'au sommet du fil 20.

Divers modes de réalisation avec diverses variantes ont été décrits ci-dessus. On note que l'homme de l'art peut combiner divers éléments de ces divers modes de réalisation et variantes sans faire preuve d'activité inventive. En particulier, la structure de la région 14 représentée en figure 20 comprenant une région fortement dopée 152 et une région moins fortement dopée 154 peut être mise en oeuvre avec les autres modes de réalisation décrits notamment en relation avec les figures 1 à 9, 12 à 14 et 16. L'invention est définie par les revendications.

## Revendications

1. Dispositif optoélectronique (5) comprenant :
un substrat (10) semiconducteur en silicium non dopé ou dopé d'un premier type de conductivité ;
une première région semiconductrice (14 ; 14₁, 14₂) en silicium, reliée électriquement au substrat, s'étendant dans le substrat ou sur le substrat au contact du substrat, dopée du premier type de conductivité ou d'un deuxième type de conductivité opposé au premier type, et plus fortement dopée que le substrat, la première région semiconductrice comprenant une face ;
des plots de germination (16) ou une couche de germination au contact de la première région semiconductrice et reposant sur la face ;
un premier ensemble (A ; A1, A2) de premières diodes électroluminescentes (DEL ; DEL₁, DEL₂) reposant sur la première région semiconductrice, les premières diodes électroluminescentes comprenant des éléments semiconducteurs, majoritairement en un composé III-V, filaires, coniques ou tronconiques et au contact des plots de germination ou de la couche de germination et comprenant des couches actives recouvrant les faces latérales des éléments semiconducteurs ;
une portion conductrice (36 ; 36₁, 36₂) au contact de la première région semiconductrice ; et
une deuxième région semiconductrice (98 ; 103) reliée électriquement au substrat (10) et distante de la première région semiconductrice, du même type de conductivité que la première région semiconductrice (14), plus fortement dopée que le substrat (10), et reliée à une première électrode (30) des premières diodes électroluminescentes (DEL).

2. Dispositif optoélectronique selon la revendication 1, dans lequel la première région semiconductrice (14 ; 14₁, 14₂) est obtenue par une ou plusieurs étapes d'implantation ionique.

3. Dispositif optoélectronique selon la revendication 1, dans lequel la première région semiconductrice (14 ; 14₁, 14₂) est obtenue par une étape d'homo-épitaxie.

4. Dispositif optoélectronique selon l'une quelconque des revendications 1 à 3, comprenant, en outre, la première couche d'électrode (30), au moins partiellement transparente, recouvrant chaque première diode électroluminescente (DEL) et une première couche conductrice (32 ; 32₁, 32₂) recouvrant la première couche d'électrode autour des premières diodes électroluminescentes.

5. Dispositif optoélectronique selon l'une quelconque des revendications 1 à 4, comprenant, en outre, au moins une portion isolante (52 ; 76) s'étendant le long d'au moins un bord latéral de la première région semiconductrice (14 ; 14₁, 14₂).

6. Dispositif optoélectronique selon l'une quelconque des revendications 1 à 3, comprenant, en outre, au moins une troisième région semiconductrice (72) dopée d'un type de conductivité opposé à la première région semiconductrice (14) et s'étendant le long d'au moins un bord latéral de la première région semiconductrice (14).

7. Dispositif optoélectronique selon l'une quelconque des revendications 1 à 6, dans lequel le substrat (10) est monolithique.

8. Dispositif optoélectronique selon l'une quelconque des revendications 1 à 6, dans lequel le substrat (10) est divisé en une couche semiconductrice (44), contenant la première région semiconductrice (14), et séparée du reste du substrat par une couche isolante (48).

9. Dispositif optoélectronique selon l'une quelconque des revendications 1 à 8, dans lequel la concentration de dopants du substrat (10) est inférieure ou égale à 10¹⁵ atomes/cm³ et la concentration de dopants de la première région semiconductrice (14) est comprise entre 5*10¹⁶ et 2*10²⁰ atomes/cm³.

10. Dispositif optoélectronique selon l'une quelconque des revendications 1 à 9, comprenant, en outre, au moins un composant électronique (92 ; 112) formé au moins en partie dans le substrat (10).

11. Dispositif optoélectronique selon la revendication 10, dans lequel le composant électronique (92 ; 112) est compris dans le groupe comprenant une diode, une diode Zener, une diode à avalanche, un transistor bipolaire, un transistor à effet de champ à grille métal-oxyde-semiconducteur, une résistance, une capacité métal-oxyde-semiconducteur, une capacité métal-isolant-métal, un thyristor, un varacteur, une mémoire volatile et une mémoire non volatile.

12. Dispositif optoélectronique selon l'une quelconque des revendications 1 à 11, comprenant :
une quatrième région semiconductrice (14₂) reliée électriquement au substrat (10), dopée du premier type de conductivité ou d'un deuxième type de conductivité opposé au premier type, et plus fortement dopée que le substrat ;
un deuxième ensemble (A2) de diodes électroluminescentes (DEL₂) reposant sur la quatrième région semiconductrice, les diodes électroluminescentes du deuxième ensemble comprenant des éléments semiconducteurs filaires, coniques ou tronconiques ; et
une deuxième couche d'électrode (30₂) recouvrant chaque deuxième diode électroluminescente et une deuxième couche conductrice (32₂) recouvrant la deuxième couche d'électrode autour des premières diodes électroluminescentes, la deuxième couche d'électrode ou la deuxième couche conductrice étant au contact de la première région semiconductrice.

13. Dispositif optoélectronique selon l'une quelconque des revendications 1 à 12, comprenant une cinquième région semiconductrice (96 ; 107) englobant la quatrième région semiconductrice (98).

14. Dispositif optoélectronique selon la revendication 13, dans lequel la cinquième région semiconductrice (107) englobe, en outre, la première région semiconductrice (14).

15. Dispositif optoélectronique selon l'une quelconque des revendications 1 à 14, comprenant :
- une sixième région semiconductrice (156) reliée électriquement au substrat (10), du même type de conductivité que la première région semiconductrice (14) ;
- une septième région semiconductrice (158) reliée électriquement au substrat (10), du type de conductivité opposé à la première région semiconductrice (14) ;
- une huitième région semiconductrice (162) au contact du substrat (10) et du même type de conductivité que la sixième région semiconductrice, reliée à la première région semiconductrice ou reliée à la sixième région semiconductrice ; et
- une neuvième région semiconductrice (160 ; 172) du même type de conductivité que la septième région semiconductrice,
dans lequel la neuvième région semiconductrice s'étend entre les sixième et huitième régions semiconductrices et est reliée à la septième région semiconductrice ou dans lequel la neuvième région semiconductrice s'étend entre les première et huitième régions semiconductrices, la neuvième région semiconductrice étant reliée à la septième région semiconductrice.

16. Dispositif optoélectronique selon l'une quelconque des revendications 1 à 15, comprenant une dixième et une onzième régions semiconductrices (118, 122), reliées l'une à l'autre, de types de conductivité opposés et toutes deux séparées de la première région semiconductrice (14) par au moins une portion isolante (52 ; 76) ou semiconductrice (120) s'étendant le long d'au moins un bord latéral de la première région semiconductrice (14) .

17. Dispositif optoélectronique selon l'une quelconque des revendications 1 à 16, dans lequel les plots de germination (16) ou la couche de germination sont réalisés en nitrure d'aluminium (AIN), en bore (B), en nitrure de bore (BN), en titane (Ti), en nitrure de titane (TiN), en tantale (Ta), en nitrure de tantale (TaN), en hafnium (Hf), en nitrure d'hafnium (HfN), en niobium (Nb), en nitrure de niobium (NbN), en zirconium (Zr), en borate de zirconium (ZrB₂), en nitrure de zirconium (ZrN), en carbure de silicium (SiC), en nitrure et carbure de tantale (TaCN), en nitrure de magnésium sous la forme MgₓN_{y}, où x est environ égal à 3 et y est environ égal à 2, par exemple du nitrure de magnésium selon la forme Mg₃N₂ ou du nitrure de gallium et de magnésium (MgGaN), en tungstène (W), en nitrure de tungstène (WN) ou en une combinaison de ces matériaux.

18. Dispositif optoélectronique selon l'une quelconque des revendications 1 à 16, dans lequel les plots de germination (16) ou la couche de germination sont réalisés en un nitrure, un carbure ou un borure d'un métal de transition de la colonne IV, V ou VI du tableau périodique des éléments ou une combinaison de ces composés.

## Patentansprüche

1. Optoelektronische Vorrichtung (5), die Folgendes aufweist:
ein Siliziumhalbleitersubstrat (10), das nicht dotiert ist oder mit einem ersten Leitfähigkeitstyp dotiert ist;
einen ersten Siliziumhalbleiterbereich (14; 14₁, 14₂), der elektrisch mit dem Substrat verbunden ist, sich innerhalb des Substrats oder auf der Oberseite des Substrats in Kontakt mit dem Substrat erstreckt, mit dem ersten Leitfähigkeitstyp oder mit einem dem ersten Typ entgegengesetzten, zweiten Leitfähigkeitstyp dotiert ist und stärker dotiert ist als das Substrat, wobei der erste Halbleiterbereich eine Oberfläche aufweist;
Keimfelder (16) oder eine Keimschicht, die in Kontakt mit dem ersten Halbleiterbereich stehen bzw. steht und auf der Oberfläche aufliegen bzw. aufliegt;
eine erste Anordnung (A; A1, A2) von ersten Leuchtdioden (DEL; DEL₁, DEL₂), die von dem ersten Halbleiterbereich getragen werden, wobei die ersten Leuchtdioden Halbleiterelemente aufweisen, die hauptsächlich aus einer III-V-Verbindung hergestellt sind, fadenförmig, kegelförmig oder kegelstumpfförmig sind und in Kontakt mit den Keimfeldern oder mit der Keimschicht stehen und aktive Schichten aufweisen, die die Seitenflächen der Halbleiterelemente bedecken;
einen leitenden Abschnitt (36; 36₁, 36₂) in Kontakt mit dem ersten Halbleiterbereich; und
einen zweiten Halbleiterbereich (98; 103), der elektrisch mit dem Substrat (10) verbunden und von dem ersten Halbleiterbereich entfernt ist, vom gleichen Leitfähigkeitstyp wie der erste Halbleiterbereich (14) ist, stärker dotiert ist als das Substrat (10) und mit einer ersten Elektrode (30) der ersten Leuchtdioden (DEL) verbunden ist.

2. Optoelektronische Vorrichtung nach Anspruch 1, wobei der erste Halbleiterbereich (14; 14₁, 14₂) durch einen oder mehrere lonenimplantationsschritte erhalten wird.

3. Optoelektronische Vorrichtung nach Anspruch 1, wobei der erste Halbleiterbereich (14; 14₁, 14₂) durch einen Homoepitaxieschritt erhalten wird.

4. Optoelektronische Vorrichtung nach einem der Ansprüche 1 bis 3, die ferner die erste Elektrodenschicht (30), die zumindest teilweise transparent ist und jede erste Leuchtdiode (DEL) bedeckt, und wobei eine erste leitende Schicht (32; 32₁, 32₂) die erste Elektrodenschicht um die ersten Leuchtdioden herum bedeckt.

5. Optoelektronische Vorrichtung nach einem der Ansprüche 1 bis 4, die ferner mindestens einen isolierenden Abschnitt (52; 76) aufweist, der sich entlang mindestens einer Seitenkante des ersten Halbleiterbereichs (14; 14₁, 14₂) erstreckt.

6. Optoelektronische Vorrichtung nach einem der Ansprüche 1 bis 3, die ferner mindestens einen dritten Halbleiterbereich (72) aufweist, der mit einem Leitfähigkeitstyp dotiert ist, der dem des ersten Halbleiterbereichs (14) entgegengesetzt ist, und sich entlang mindestens einer Seitenkante des ersten Halbleiterbereichs (14) erstreckt.

7. Optoelektronische Vorrichtung nach einem der Ansprüche 1 bis 6, wobei das Substrat (10) monolithisch ist.

8. Optoelektronische Vorrichtung nach einem der Ansprüche 1 bis 6, wobei das Substrat (10) unterteilt ist in eine Halbleiterschicht (44), die den ersten Halbleiterbereich (14) enthält, und vom Rest des Substrats durch eine Isolierschicht (48) getrennt ist.

9. Optoelektronische Vorrichtung nach einem der Ansprüche 1 bis 8, wobei die Dotierstoffkonzentration des Substrats (10) kleiner oder gleich 10¹⁵ Atome/cm³ ist und die Dotierstoffkonzentration des ersten Halbleiterbereichs (14) im Bereich von 5*10¹⁶ bis 2*10²⁰ Atome/cm³ liegt.

10. Optoelektronische Vorrichtung nach einem der Ansprüche 1 bis 9, die ferner mindestens ein elektronisches Bauelement (92; 112) aufweist, das zumindest teilweise in dem Substrat (10) ausgebildet ist.

11. Optoelektronische Vorrichtung nach Anspruch 10, wobei das elektronische Bauelement (92; 112) zu der Gruppe gehört, die eine Diode, eine Zener-Diode, eine Avalanche-Diode, einen Bipolartransistor, einen Metall-Oxid-Halbleiter-Feldeffekttransistor, einen Widerstand, einen Metall-Oxid-Halbleiter-Kondensator, einen Metall-Isolator-Metall-Kondensator, einen Thyristor, einen Varaktor, einen flüchtigen Speicher und einen nichtflüchtigen Speicher aufweist.

12. Optoelektronische Vorrichtung nach einem der Ansprüche 1 bis 11, die Folgendes aufweist:
einen vierten Halbleiterbereich (14₂), der elektrisch mit dem Substrat (10) verbunden ist, mit dem ersten Leitfähigkeitstyp oder einem zweiten Leitfähigkeitstyp, der dem ersten Typ entgegengesetzt ist, dotiert ist und stärker dotiert ist als das Substrat;
eine zweite Anordnung (A2) von Leuchtdioden (DEL₂), die von dem vierten Halbleiterbereich getragen wird, wobei die Leuchtdioden der zweiten Anordnung fadenförmige, kegelförmige oder kegelstumpfförmige Halbleiterelemente aufweisen; und
eine zweite Elektrodenschicht (30₂), die jede zweite Leuchtdiode bedeckt, und eine zweite leitende Schicht (32₂), die die zweite Elektrodenschicht um die ersten Leuchtdioden herum bedeckt, wobei die zweite Elektrodenschicht oder die zweite leitende Schicht in Kontakt mit dem ersten Halbleiterbereich ist.

13. Optoelektronische Vorrichtung nach einem der Ansprüche 1 bis 12, mit einem fünften Halbleiterbereich (96; 107), der den vierten Halbleiterbereich (98) umgibt.

14. Optoelektronische Vorrichtung nach Anspruch 13, wobei der fünfte Halbleiterbereich (107) ferner den ersten Halbleiterbereich (14) umgibt.

15. Optoelektronische Vorrichtung nach einem der Ansprüche 1 bis 14, die Folgendes aufweist:
- einen sechsten Halbleiterbereich (156), der elektrisch mit dem Substrat (10) verbunden ist und vom gleichen Leitfähigkeitstyp ist wie der erste Halbleiterbereich (14);
- einen siebten Halbleiterbereich (158), der elektrisch mit dem Substrat (10) verbunden ist und einen Leitfähigkeitstyp aufweist, der dem des ersten Halbleiterbereichs (14) entgegengesetzt ist;
- einen achten Halbleiterbereich (162) in Kontakt mit dem Substrat (10) und vom gleichen Leitfähigkeitstyp wie der sechste Halbleiterbereich, wobei der achte Halbleiterbereich mit dem ersten Halbleiterbereich verbunden ist oder mit dem sechsten Halbleiterbereich verbunden ist; und
- einen neunten Halbleiterbereich (160; 172) mit dem gleichen Leitfähigkeitstyp wie der siebte Halbleiterbereich,
wobei sich der neunte Halbleiterbereich zwischen dem sechsten und achten Halbleiterbereich erstreckt und mit dem siebten Halbleiterbereich verbunden ist, oder wobei sich der neunte Halbleiterbereich zwischen dem ersten und achten Halbleiterbereich erstreckt und mit dem siebten Halbleiterbereich verbunden ist.

16. Optoelektronische Vorrichtung nach einem der Ansprüche 1 bis 15, mit einem zehnten und einem elften Halbleiterbereich (118, 122), die miteinander verbunden sind, entgegengesetzte Leitfähigkeitstypen aufweisen und beide von dem ersten Halbleiterbereich (14) durch mindestens einen isolierenden (52; 76) oder halbleitenden (120) Abschnitt getrennt sind, der sich entlang mindestens einer Seitenkante des ersten Halbleiterbereichs (14) erstreckt.

17. Optoelektronische Vorrichtung nach einem der Ansprüche 1 bis 16, wobei die Keimfelder (16) oder die Keimschicht aus Aluminiumnitrid (AlN), aus Bor (B), aus Bornitrid (BN), aus Titan (Ti) aus Titannitrid (TiN), aus Tantal (Ta), aus Tantalnitrid (TaN), aus Hafnium (Hf), aus Hafniumnitrid (HfN), aus Niob (Nb), aus Niobnitrid (NbN), aus Zirkonium (Zr), aus Zirkoniumborat (ZrB₂), aus Zirkoniumnitrid (ZrN), aus Siliciumcarbid (SiC), aus Tantalcarbonnitrid (TaCN), aus Magnesiumnitrid in Form von MgₓN_{y}, wobei x ungefähr gleich 3 und y ungefähr gleich 2 ist, z.B. Magnesiumnitrid in Form von Mg₃N₂ oder Magnesiumgalliumnitrid (MgGaN), aus Wolfram (W), aus Wolframnitrid (WN) oder aus einer Kombination dieser Materialien gebildet sind.

18. Optoelektronische Vorrichtung nach einem der Ansprüche 1 bis 16, wobei die Keimfelder (16) oder die Keimschicht aus einem Nitrid, einem Carbid oder einem Borid eines Übergangsmetalls aus Spalte IV, V oder VI des Periodensystems der Elemente oder einer Kombination dieser Verbindungen bestehen.

## Claims

1. An optoelectronic device (5) comprising:
a semiconductor silicon substrate (10), non-doped or doped with a first conductivity type;
a first doped semiconductor silicon region (14; 14₁, 14₂), electrically connected to the substrate, extending inside of the substrate or on top of the substrate in contact with the substrate, of the first conductivity type or of a second conductivity type opposite to the first type, and more heavily doped than the substrate, the first semiconductor region comprising a surface;
seed pads (16) or a seed layer in contact with the first semiconductor region and resting on the surface;
a first assembly (A; A1, A2) of first light-emitting diodes (DEL; DEL₁, DEL₂) supported by the first semiconductor region, the first light-emitting diodes comprising semiconductor elements, mainly made of a III-V compound, having a wire, conical, or tapered shape and in contact with the seed pads or with the seed layer and comprising active layers covering the lateral faces of the semiconductor elements;
a conductive portion (36; 36₁, 36₂) in contact with the first semiconductor region; and
a second semiconductor region (98; 103) electrically connected to the substrate (10) and distant from the first semiconductor region, of the same conductivity type as the first semiconductor region (14), more heavily doped than the substrate (10), and connected to a first electrode (30) of the first light-emitting diodes (DEL).

2. The optoelectronic device of claim 1, wherein the first semiconductor region (14; 14₁, 14₂) is obtained by one or a plurality of ion implantation steps.

3. The optoelectronic device of claim 1, wherein the first semiconductor region (14; 14₁, 14₂) is obtained by a homoepitaxy step.

4. The optoelectronic device of any of claims 1 to 3, further comprising the first electrode layer (30), at least partially transparent, covering each first light-emitting diode (DEL) and a first conductive layer (32; 32₁, 32₂) covering the first electrode layer around the first light-emitting diodes.

5. The optoelectronic device of any of claims 1 to 4, further comprising at least one insulating portion (52; 76) extending along at least one lateral edge of the first semiconductor region (14; 14₁, 14₂).

6. The optoelectronic device of any of claims 1 to 3, further comprising at least one third doped semiconductor region (72) of a conductivity type opposite to that of the first semiconductor region (14) and extending along at least one lateral edge of the first semiconductor region (14).

7. The optoelectronic device of any of claims 1 to 6, wherein the substrate (10) is monolithic.

8. The optoelectronic device of any of claims 1 to 6, wherein the substrate (10) is divided into a semiconductor layer (44), containing the first semiconductor region (14), and separated from the rest of the substrate by an insulating layer (48).

9. The optoelectronic device of any of claims 1 to 8, wherein the dopant concentration of the substrate (10) is smaller than or equal to 10¹⁵ atoms/cm³ and the dopant concentration of the first semiconductor region (14) is in the range from 5*10¹⁶ to 2*10²⁰ atoms/cm³.

10. The optoelectronic device of any of claims 1 to 9, further comprising at least one electronic component (92; 112) at least partly formed in the substrate (10).

11. The optoelectronic device of claim 10, wherein the electronic component (92; 112) belongs to the group comprising a diode, a zener diode, an avalanche diode, a bipolar transistor, a metal-oxide-semiconductor field-effect transistor, a resistor, a metal-oxide-semiconductor capacitance, a metal-insulator-metal capacitance, a thyristor, a varactor, a volatile memory, and a nonvolatile memory.

12. The optoelectronic device of any of claims 1 to 11, comprising:
a fourth doped semiconductor region (14₂) electrically connected to the substrate (10), of the first conductivity type or of a second conductivity type opposite to the first type, and more heavily doped than the substrate;
a second assembly (A2) of light-emitting diodes (DEL₂) supported by the fourth semiconductor region, the light-emitting diodes of the second assembly comprising wire, conical, or tapered semiconductor elements; and
a second electrode layer (30₂) covering each second light-emitting diode and a second conductive layer (32₂) covering the second electrode layer around the first light-emitting diodes, the second electrode layer or the second conductive layer being in contact with the first semiconductor region.

13. The optoelectronic device of any of claims 1 to 12, comprising a fifth semiconductor region (96; 107) containing the fourth semiconductor region (98).

14. The optoelectronic device of claim 13, wherein the fifth semiconductor region (107) further contains the first semiconductor region (14).

15. The optoelectronic device of any of claims 1 to 14, comprising:
- a sixth semiconductor region (156) electrically connected to the substrate (10), of the same conductivity type as the first semiconductor region (14);
- a seventh semiconductor region (158) electrically connected to the substrate (10), of a conductivity type opposite to that of the first semiconductor region (14);
- an eighth semiconductor region (162) in contact with the substrate (10) and of the same conductivity type as the sixth semiconductor region, connected to the first semiconductor region or connected to the sixth semiconductor region; and
- a ninth semiconductor region (160; 172) of the same conductivity type as the seventh semiconductor region,
wherein the ninth semiconductor region extends between the sixth and eighth semiconductor regions and is connected to the seventh semiconductor region or wherein the ninth semiconductor region extends between the first and eighth semiconductor regions, the ninth semiconductor region being connected to the seventh semiconductor region.

16. The optoelectronic device of any of claims 1 to 15, comprising a tenth and an eleventh semiconductor regions (118, 122), connected to each other, of opposite conductivity types and both separated from the first semiconductor region (14) by at least one insulating (52; 76) or semiconductor (120) portion extending along at least one lateral edge of the first semiconductor region (14) .

17. The optoelectronic device of any of claims 1 to 16, wherein the seed pads (16) or the seed layer are made of aluminum nitride (AlN), of boron (B), of boron nitride (BN), of titanium (Ti), of titanium nitride (TiN), of tantalum (Ta), of tantalum nitride (TaN), of hafnium (Hf), of hafnium nitride (HfN), of niobium (Nb), of niobium nitride (NbN), of zirconium (Zr), of zirconium borate (ZrB₂), of zirconium nitride (ZrN), of silicon carbide (SiC), of tantalum carbo-nitride (TaCN), of magnesium nitride in MgₓN_{y} form, where x is approximately equal to 3 and y is approximately equal to 2, for example, magnesium nitride in Mg₃N₂ form or magnesium gallium nitride (MgGaN), of tungsten (W), of tungsten nitride (WN), or of a combination of these materials.

18. The optoelectronic device of any of claims 1 to 16, wherein the seed pads (16) or the seed layer are made of a nitride, a carbide, or a boride of a transition metal from column IV, V, or VI of the periodic table of elements or a combination of these compounds.
